# EUROPEAN PATENT SPECIFICATION

(11) **EP 3 364 533 B1**
(45) Date of publication and mention of the grant of the patent: **18.09.2019**
(21) Application number: 17156735.7
(22) Date of filing: 17.02.2017
(51) Int. Cl.: H02M 1/02, H02M 1/06, H02M 1/32

(54) **IMPROVEMENTS IN OR RELATING TO GATE DRIVERS FOR GAS TUBES**
VERBESSERUNGEN AN ODER IM ZUSAMMENHANG MIT GATE-TREIBERN FÜR GASENTLADUNGSRÖHRE
PERFECTIONNEMENT APPORTÉS OU SE RAPPORTANT AUX CIRCUIT D'ATTAQUE DE GRILLE POUR TUBE À DÉCHARGE

(43) Date of publication of application: 22.08.2018
(73) Proprietor: General Electric Technology GmbH, 5400 Baden (CH)
(72) Inventor: DAVIDSON, Colin Charnock, Stafford, Staffordshire ST17 4PS (GB)
(74) Representative: Openshaw & Co.

(56) References cited:
- GB-A- 812 103
- JP-A- S5 553 177
- US-A- 3 311 784
- US-A- 5 237 225

## Description

This invention relates to a regulated voltage source for a gate driver of a switching device having a gate terminal via which the switching device can at least be turned on, such a gate driver, a gate driver assembly, and a gas tube switching device having such a gate driver or gate driver assembly operatively connected with its gate terminal.

GB812103 (A) discusses improvements in or relating to grid-controlled current converters. US3311784 (A) relates to electrical control circuits for mercury-arc type rectifiers. US5237225 (A) discloses a switching arrangement for an RF-gate turn-off thyristor (GTO). JPS5553177 (A) discloses a driving circuit of a GTO.

According to a first aspect of the invention there is provided a regulated voltage source, for a gate driver for a gas tube switching device having a gate terminal via which the switching device can at least be turned on, the regulated voltage source comprising:
an input terminal via which the regulated voltage source in use receives current;
first and second output terminals via at least one of which the regulated voltage source in use applies a voltage to a gate terminal of a switching device;
a regulated energy storage stage electrically connected between the input and output terminals and including a primary energy storage device connected in parallel with a storage limiter to limit the amount of energy stored in the primary energy storage device and between which lies an energy retainer to prevent the escape of energy from the primary energy storage device via the storage limiter;
a freewheel diode arranged in parallel with the energy storage stage; and
a secondary energy storage device arranged in parallel with each of the freewheel diode and the energy storage stage.

The inclusion of a secondary energy storage device arranged in parallel with each of the freewheel diode and the energy storage stage is advantageous because it helps to temporarily maintain a uniform voltage across the energy retainer when the primary energy storage device reaches the end of a charging phase. Temporarily maintaining such a uniform voltage reduces the stress that would otherwise be placed on the energy retainer. In addition, avoiding a sudden step change in voltage across the energy retainer prevents such a voltage change being reflected, in use, across an associated switching device which might otherwise lead to interference.

The secondary energy storage device may have a smaller storage capacity than the primary energy storage device.

Having a smaller capacity secondary energy storage device is beneficial because it reduces significantly the cost of the secondary energy storage device while still providing the aforementioned benefit of temporarily maintaining a uniform voltage across the energy retainer at the end of a primary energy storage device charging phase.

Preferably the storage limiter has a discharge limiting element connected in series therewith.

Including a discharge limiting element in series with the storage limiter assists with limiting the rate at which the secondary energy storage device discharges when the storage limiter operates to establish the desired energy storage limit of the primary energy storage device. Limiting the discharge rate of the secondary energy storage device, in turn prevents a dangerously high surge of current flowing from the secondary energy storage device through the storage limiter which would otherwise likely destroy the storage limiter.

Optionally the discharge limiting element is or includes one of an inductor and a resistor.

Such a discharge limiting element desirably limits the rate of discharge of the secondary energy storage device without the need for any external intervention.

According to a second aspect of the invention there is provided a gate driver, for a gas tube switching device having a gate terminal via which the switching device can at least be turned on, comprising a regulated voltage source as described hereinabove.

The gate driver shares the benefits associated with the regulated voltage source included therein.

In a preferred embodiment of the invention the first and second output terminals of the regulated voltage source have a switching stage electrically connected therewith to in use selectively interconnect the primary energy storage device of the regulated voltage source with a gate terminal of a switching device.

Including a switching stage introduces a desired degree of control over at least the turning on of a given switching device.

The switching stage may in use selectively provide a first switching path between the primary energy storage device and the gate terminal to apply a voltage at a first polarity to the gate terminal.

The selective provision of a first switching path advantageously provides the gate terminal with, e.g. the positive polarity voltage required to turn the switching device on.

Optionally the switching stage in use selectively provides a second switching path between the primary energy storage device and the gate terminal to apply a voltage at a second opposite polarity to the gate terminal.

The selective provision of a second switching path desirably provides the gate terminal with, e.g. the negative polarity voltage required to force a given switching device to turn off.

The switching stage may include a full-bridge switching arrangement to selectively provide the first and second switching paths.

Such a switching arrangement provides for a simple and thereby cost-effective gate driver.

In another preferred embodiment of the invention the switching stage additionally includes an isolating transformer.

The inclusion of an isolating transformer advantageously allows, in use, a negative terminal of each of the primary and secondary energy storage devices to be connected directly to a cathode terminal of a switching device with which the gate driver is operatively associated.

According to a third aspect of the invention there is provided a gate driver assembly comprising first and second gate drivers as described herein above, the first gate driver having a first switching stage which in use selectively provides a first switching path between a first primary energy storage device of the first gate driver and the gate terminal of a switching device to apply a voltage at a first polarity to the said gate terminal, and the second gate driver having a second switching stage which in use selectively provides a second switching path between a second primary energy storage device of the second gate driver and the gate terminal of the said switching device to apply a voltage at a second polarity, opposite to the first polarity, to the said gate terminal.

The inclusion of first and second gate drivers, and more particularly their respective first and second primary energy storage devices, allows for a tailoring of the characteristics of each driver to suit, e.g. the magnitude of the voltage that must be applied to the gate terminal of a switching device to affect turning on and turning off of the said switching device.

According to a fourth aspect of the invention there is provided a gas tube switching device comprising:
a gate terminal via which it can be turned on and turned off; and
a gate driver as described hereinabove operatively connected with the gate terminal to selectively apply a voltage at a first polarity to the gate terminal to turn the gas tube on and selectively apply a voltage at a second polarity opposite the first polarity to the gate terminal to turn the gas tube off.

The gas tube switching device shares the benefits associated with the gate driver or gate driver assembly included therein.

There now follows a brief description of preferred embodiments of the invention with reference being made to the following figures in which:
Figure 1 shows a regulated voltage source according to a first embodiment of the invention which in turn forms a part of a first gate driver according to a second embodiment of the invention;
Figure 2 shows a second gate driver according to a third embodiment of the invention which includes the same regulated voltage source as shown in Figure 1; and
Figure 3 shows a gate driver assembly according to a fourth embodiment of the invention which includes first and second regulated voltage sources, as shown in Figure 1.

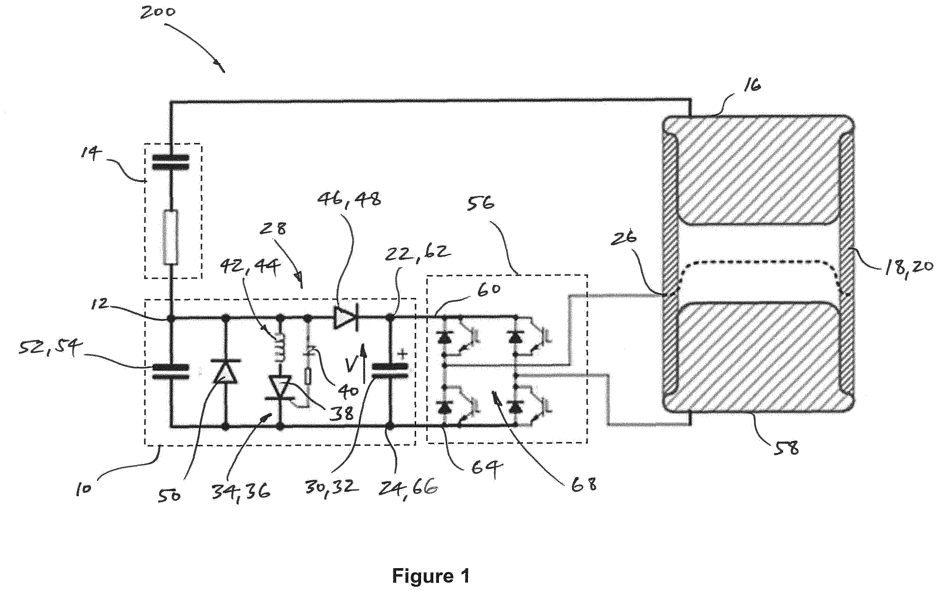

A regulated voltage source according to a first embodiment of the invention is designated generally by reference numeral 10, as shown in Figure 1.

The regulated voltage source 10 includes an input terminal 12 via which the regulated voltage source 10 in use receives current. More particularly, the input terminal 12 is, in use, connected in series with a resistor-capacitor damping stage 14 which, in turn, is electrically connected with an anode terminal 16 of a switching device 18 in the form of a gas tube 20.

In addition the regulated voltage source 10 includes first and second output terminals 22, 24 via each of which the regulated voltage source 10 in use applies a voltage to a gate terminal 26 of the said switching device 18, i.e. the said gas tube 20.

The regulated voltage source 10 also includes a regulated energy storage stage 28 which is electrically connected between the input and output terminals 12, 22, 24.

The regulated voltage source 10 also includes a regulated energy storage stage 28 which is electrically connected between the input and output terminals 12, 22, 24.

The regulated energy storage stage 28 includes a primary energy storage device 30 which, in the embodiment shown, takes the form of a primary capacitor 32, although other types of energy storage device may be used.

The primary energy storage device 30 is connected in parallel with a storage limiter 34 which is configured to limit the amount of energy stored in the primary energy storage device 30, i.e. in the primary capacitor 32. In the embodiment shown, the storage limiter 34 includes a self-triggered switching element 36, and more particularly still includes a limiting thyristor 38 arranged in combination with a breakover diode 40.

The storage limiter 34, i.e. the self-triggered switching element 36, is configured to remain turned off while the voltage applied thereacross, i.e. while the voltage across the primary energy storage device 30, is below a desired level corresponding to the breakover voltage of the breakover diode 40, and to turn on when the voltage applied thereacross, i.e. when the voltage across the primary energy storage device 40, is greater than or equal to the desired level, i.e. greater than or equal to the breakover voltage of the breakover diode 40.

Other types of storage limiter may, however, be used.

In the embodiment shown the storage limiter 34, i.e. the limiting thyristor 38 and breakover diode 40 combination, has a discharge limiting element 42 in the form of a limiting inductor 44 connected in series therewith, although in other embodiments of the invention a resistor may be included instead.

Between the storage limiter 34 and the primary energy storage device 30 lies an energy retainer 46 that is configured to prevent the escape of energy from the primary energy storage device 30 via the storage limiter 34. In the embodiment shown the energy retainer 46 is a retaining diode 48, although other types of energy retainer may also be used.

In addition to the foregoing the regulated voltage source 10 includes a freewheel diode 50 which is arranged in parallel with the energy storage stage 28.

The regulated voltage source 10 still further includes a secondary energy storage device 52 that is arranged in parallel with each of the freewheel diode 50 and the energy storage stage 28. In the embodiment shown the secondary energy storage device 52 is a secondary capacitor 54, although other types of energy storage device may be used. In any event, the secondary energy storage device 52 has a smaller storage capacity than the primary energy storage device 30.

In the example embodiment shown, the first and second output terminals 22, 24 of the regulated voltage source 10 have a switching stage 56 electrically connected therewith. In this manner the regulated voltage source 10, resistor-capacitor damping stage 14 and the switching stage 56 together define a first gate driver 200 according to a further, second embodiment of the invention.

More particularly, in the embodiment shown, the switching stage 56 is operatively associated with the gate terminal 26 of the aforementioned switching device 18, i.e. the aforementioned gas tube 20 to, in use, selectively interconnect the primary energy storage device 30, i.e. the primary capacitor 32, with the said gate terminal 26. In addition the switching stage 56 is, in the embodiment shown, electrically connected with a cathode terminal 58 of the switching device 30.

More particularly still, the switching stage 56 selectively provides a first switching path 60 between the primary energy storage device 30 and the gate terminal 26 to apply a voltage at a first polarity to the gate terminal 26. In the embodiment shown the first switching path 60 selectively extends between a positive terminal 62 of the primary energy storage device 30, i.e. the primary capacitor 32, and the gate terminal 26 and thereby selectively applies the voltage V stored by the primary capacitor 32 at a positive polarity to the gate terminal 26 to turn the switching device 18 on.

The switching stage 56 additionally selectively provides a second switching path 64 between the primary energy storage device 30 and the gate terminal 26 to apply a voltage at a second polarity, opposite the first polarity, to the gate terminal 26. In the embodiment shown the second switching path 64 selectively extends between a negative terminal 66 of the primary energy storage device 30, i.e. the primary capacitor 32, and the gate terminal 26 and thereby selectively applies the voltage V stored by the primary capacitor 32 at a negative polarity to the gate terminal 26 to force the switching device 18 to turn off.

A full-bridge switching arrangement 68 is included in the switching stage 56 to selectively provide the aforementioned first and second switching paths 60, 64 although other arrangements may instead be used, as well as different first and second switching paths provided.

In use, during a bypass phase in the operation of the first gate driver 200 when the switching device 18 is off and the voltage between its anode and cathode terminals 16, 58 is falling (i.e. becoming less positive or more negative), current flows from the second output terminal 24 of the regulated voltage source 10, through the freewheel diode 50 thereof (thereby bypassing the primary energy storage device 30), and out through the input terminal 12 of the regulated voltage source 10. During this phase no power is extracted by the regulated voltage source 10 and hence no energy is stored within the primary energy storage device 30.

In contrast, during a charging phase in the operation of the first gate driver 200 when the switching device 18 is still off but the voltage between its anode and cathode terminals 16, 58 is rising (i.e. becoming more positive or less negative), current flows from the resistor-capacitor damping stage 14, into the input terminal 12 of the regulated voltage source 10 and through the parallel combination of the primary and secondary energy storage devices 30, 52, i.e. the parallel combination of the primary and secondary capacitors 32, 54.

Both the primary and secondary capacitors 32, 54 are typically rated at a much lower voltage than the capacitor included in the resistor-capacitor damping stage 14, e.g. 1kV compared to 100kV. As a consequence, the primary and secondary capacitors 32, 54 store energy at a much lower voltage V, e.g. 1kV, than the varying voltage across the anode and cathode terminals 16, 58 of the switching device 18 which, for example, can be around 100kV.

When the voltage across the parallel combination of the primary and secondary capacitors 32, 54 reaches a desired level, i.e. voltage V, which corresponds to the breakover voltage of the breakover diode 40, the breakover diode 40 turns on which in turn causes the limiting thyristor 38 to turn on.

Turn on of the limiting thyristor 38 discharges the secondary energy storage device 52, i.e. the secondary capacitor 54, via the limiting inductor 44 connected in series with the limiting thyristor 38, which causes the voltage across the secondary capacitor 54 to fall to zero and the current through the limiting thyristor 38 to freewheel through the freewheel diode 50 after reaching its initial peak. Meanwhile the inclusion of the limiting inductor 44, i.e. some form of discharge limiting element 42, helps to ensure that the secondary energy storage device 52 does not discharge too quickly through the limiting thyristor 38. This in turn helps to keep the initial peak current flowing through the limiting thyristor 38 below a safe operating level and so prevents destruction of the limiting thyristor 38.

The limiting thyristor 38 remains turned on until the sum of the freewheeling current and the current fed into the regulated voltage source 10 from the resistor-capacitor damping stage 14 falls below a holding current of the said limiting thyristor 38.

The primary storage capacitor 32 is, however, prevented from discharging by the energy retainer 46, i.e. by the retaining diode 48.

The secondary capacitor 54 then begins to charge up again, initially quickly because the voltage thereacross is lower than that across the primary capacitor 32 and the retaining diode 48 remains reverse-biased so that current can only flow through the secondary capacitor 54. Once the voltages across the primary and secondary capacitors 32, 54 equate to one another again, current is once more able to flow into the larger primary capacitor 32 and so the secondary capacitor 54 charges more slowly.

Having charged the primary and secondary capacitors 32, 54 the current returns to the cathode terminal 58 of the switching device 18 via an anti-parallel diode in one of the switches within the full-bridge switching arrangement 68 to complete the aforesaid charging phase.

At such an end of the charging phase, i.e. when the voltage between the anode and cathode terminals 16, 58 of the switching device 18 reaches its peak, the current flowing through the resistor-capacitor damping stage 14 falls to zero. However, the secondary capacitor 54 temporarily maintains a uniform voltage across the energy retainer 46, i.e. the retaining diode 48 before progressively discharging in a controlled manner, i.e. in a manner limited by the limiting inductor 44. This leads to a soft and gentle recovery, i.e. switching off, of the energy retainer 46 which places little or no stress on the said energy retainer 46. In addition, providing a progressive reduction in the voltage across the energy retainer 46 prevents a sudden step change in voltage arising across the anode and cathode terminals 16, 58 of the switching device 18 which might otherwise lead to interference.

Meanwhile, during a turn on phase in the operation of the first gate driver 200, the switching stage 56 establishes the first switching path 60 between the positive terminal 62 of the primary energy storage device 30, i.e. the primary capacitor 32, and the gate terminal 26 of the switching device 18, and applies the voltage V stored by the primary capacitor 32 at a positive polarity to the gate terminal 26 to turn the switching device 18 on.

Similarly, during a turn off phase in the operation of the first gate driver 200, the switching stage 56 establishes the second switching path 64 between the negative terminal 66 of the primary energy storage device 30, i.e. the primary capacitor 32, and the gate terminal 26 of the switching device 18, and applies the voltage V stored by the primary capacitor 32 at a negative polarity to the gate terminal 26 to force the switching device 18 to turn off.

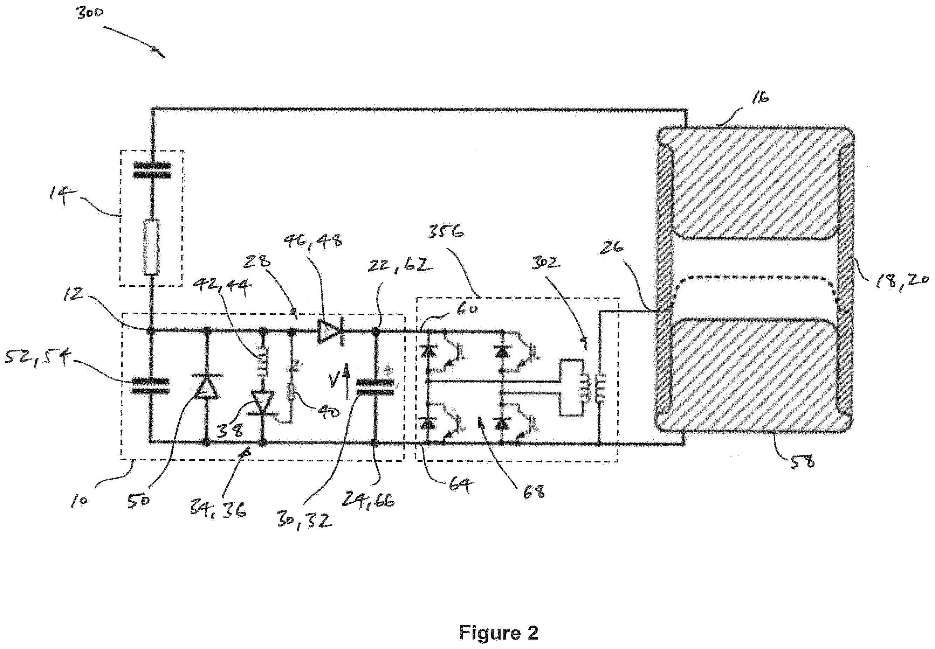

A second gate driver according to a third embodiment of the invention is designated generally by reference numeral 300, and is shown schematically in Figure 2.

The second gate driver 300 is very similar to the first gate driver 200 shown schematically in Figure 1 and like features share the same reference numerals.

However, the second gate driver 300 differs from the first gate driver 200 in that it has a switching stage 356 which also includes an isolating transformer 302. The isolating transformer 302 lies between the switching stage 356 and the gate and cathode terminals 26, 58 of the switching device 18 with which the second gate driver 300 is, in use, operatively connected, and allows the negative terminal 66 of the primary energy storage device 30, i.e. the primary capacitor 32, to be connected directly with the cathode terminal 58 of the switching device 18.

The second gate driver 300 otherwise functions in the same manner as the first gate driver 200, i.e. as described hereinabove.

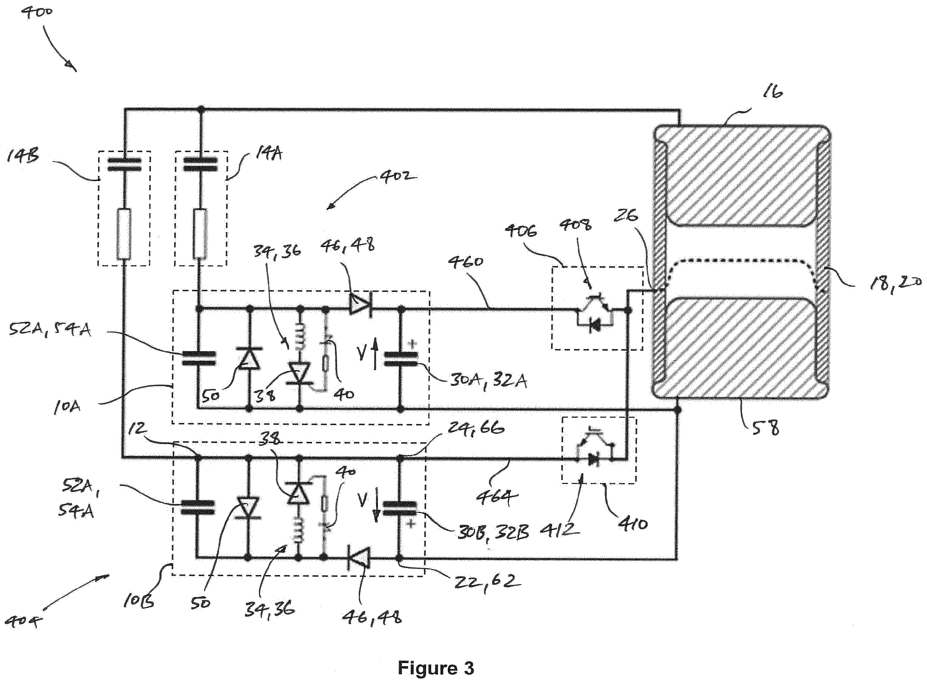

A gate driver assembly according to a fourth embodiment of the invention is designated generally by reference numeral 400, and is shown schematically in Figure 3. The gate driver assembly 400 shares some features with the first and second gate drivers 200; 300 and like features are designated by the same reference numerals.

The gate driver assembly 400 does however include first and second gate drivers 402, 404, each of which includes a regulated voltage source 10A, 10B according to the first embodiment of the invention.

The first gate driver 402 includes a first switching stage 406 which, in use, selectively provides a first switching path 460 between a first primary energy storage device 30A, i.e. a first primary capacitor 32A, in the first regulated voltage source 10A and the gate terminal 26 of a switching device 18 with which the gate driver assembly 400 is, in use, operatively associated.

More particularly, the first switching stage 406 includes a first switching element 408 which, in the embodiment shown, is a controllable first switching element in the form of an insulated-gate bipolar transistor (IGBT) connected in parallel with an anti-parallel diode. Other first switching elements may, however, also be used.

The first switching element 408 selectively interconnects, i.e. when turned on, the positive terminal 62 of the first primary capacitor 32A with the gate terminal 26 of the switching device to apply a voltage V at a first, positive polarity to the gate terminal 26 and thereby turn the switching device 18 on.

The second gate driver 404 includes a second switching stage 410 which, in use, selectively provides a second switching path 464 between a second primary energy storage device 30B, i.e. a second primary capacitor 32B, in the second regulated voltage source 10B and the gate terminal 26 of the switching device 18.

More particularly, the second switching stage 410 includes a second switching element 412 which, in the embodiment shown, is again a controllable second switching element in the form of an insulated-gate bipolar transistor (IGBT) connected in parallel with an anti-parallel diode, although other second switching elements may also be used.

The second switching element 412 selectively interconnects, i.e. when turned on, the negative terminal 64 of the second primary capacitor 32B with the gate terminal 26 of the switching device to apply a voltage V at a second, negative polarity to the gate terminal 26 and thereby force the switching device 18 to turn off.

Each of the first and second gate drivers 402, 404 is electrically connected with the anode terminal 16 of the switching device 18 via separate first and second resistor-capacitor damping stages 14A, 14B, although in other embodiments (not shown) the damping stages may share a common capacitor.

In use, during a first charging phase in the operation of the gate driver assembly 400 when the switching device 18 is off and the voltage between its anode and cathode terminals 16, 58 is rising (i.e. becoming more positive or less negative), current flows from the first resistor-capacitor damping stage 14A, into the input terminal 12 of the first regulated voltage source 10A and through the parallel combination of the first primary and secondary energy storage devices 30A, 52A, i.e. the parallel combination of the first primary and secondary capacitors 32A, 54A.

Thereafter the first primary energy storage device 30A, i.e. the first primary capacitor 32A, charges, i.e. stores energy, in the same manner as described hereinabove in connection with the regulated voltage source 10 within the first gate driver 200.

In use, during second charging phase in the operation of the gate driver assembly 400 when the switching device 18 remains off but the voltage between its anode and cathode terminals 16, 58 is falling (i.e. becoming less positive or more negative), current flows from the first output terminal 22 of the second regulated voltage source 10B and through the parallel combination of the second primary and secondary energy storage devices 30B, 52B, i.e. the parallel combination of the second primary and secondary capacitors 32B, 54B. Thereafter the second primary energy storage device 30B, i.e. the second primary capacitor 32B, charges, i.e. stores energy, in the same manner as described hereinabove in connection with the regulated voltage source 10 within the first gate driver 200.

During a turn on phase in the operation of the gate driver assembly 400, the first switching stage 406 establishes the first switching path 460 between the positive terminal 62 of the first primary energy storage device 30A, i.e. the first primary capacitor 32A, and the gate terminal 26 of the switching device 18, and applies the voltage V stored by the first primary capacitor 32A at a positive polarity to the gate terminal 26 to turn the switching device 18 on.

Similarly, during a turn off phase in the operation of the gate driver assembly 400, the second switching stage 410 establishes the second switching path 464 between the negative terminal 66 of the second primary energy storage device 30B, i.e. the second primary capacitor 32B, and the gate terminal 26 of the switching device 18, and applies the voltage V stored by the second primary capacitor 32 at a negative polarity to the gate terminal 26 to force the switching device 18 to turn off.

## Claims

1. A regulated voltage source (10; 10A, 10B) for a gate driver (200; 300) for a gas tube switching device (18) having a gate terminal (26) via which the switching device (18) can at least be turned on, the regulated voltage source (10; 10A, 10B) comprising:
an input terminal (12) via which the regulated voltage source (10; 10A, 10B) in use receives current;
first and second connection terminals (22, 24) via at least one of which the regulated voltage source (10; 10A, 10B) in use applies a voltage (V) to a gate terminal (26) of a switching device (18);
**characterized in that** the regulated voltage source further comprises:
a regulated energy storage stage (28) electrically connected between the input and output terminals (12, 22, 24) and including a primary energy storage device (30; 30A, 30B) connected in parallel with a storage limiter (34) to limit the amount of energy stored in the primary energy storage device (30; 30A, 30B) and between which lies an energy retainer (46) to prevent the escape of energy from the primary energy storage device (30; 30A, 30B) via the storage limiter (34);
a freewheel diode (50) arranged in parallel with the energy storage stage (28); and
a secondary energy storage device (52; 52A, 52B) arranged in parallel with each of the freewheel diode (50) and the energy storage stage (28).

2. A regulated voltage source (10; 10A, 10B) according to Claim 1 wherein the secondary energy storage device (52; 52A, 52B) has a smaller storage capacity than the primary energy storage device (30; 30A, 30B).

3. A regulated voltage source (10; 10A, 10B) according to Claim 1 or Claim 2 wherein the storage limiter (34) has a discharge limiting element (42) connected in series therewith.

4. A regulated voltage source (10; 10A, 10B) according to Claim 3 wherein the discharge limiting element (42) is or includes one of an inductor (44) and a resistor.

5. A gate driver (200; 300; 402, 404), for a gas tube switching device (18) having a gate terminal (26) via which the switching device (18) can at least be turned on, comprising a regulated voltage source (10; 10A, 10B) according to any preceding claim.

6. A gate driver according to Claim 5 wherein the first and second output terminals (22, 24) of the regulated voltage source (10; 10A, 10B) have a switching stage (56; 356; 406, 410) electrically connected therewith to in use selectively interconnect the primary energy storage device (30; 30A, 30B) of the regulated voltage source (10; 10A, 10B) with a gate terminal (26) of a switching device (18).

7. A gate driver (200; 300; 402) according to Claim 6 wherein the switching stage (56; 356; 406) in use selectively provides a first switching path (60; 460) between the primary energy storage device (30; 30A) and the gate terminal (26) to apply a voltage (V) at a first polarity to the gate terminal (26).

8. A gate driver (200; 300; 404) according to Claim 6 or Claim 7 wherein the switching stage (56; 356; 410)) in use selectively provides a second switching path (64; 464) between the primary energy storage device (30; 30B) and the gate terminal (26) to apply a voltage (V) at a second opposite polarity to the gate terminal (26).

9. A gate driver (200; 300) according to Claim 8 wherein the switching stage (56; 356) includes a full-bridge switching arrangement (68) to selectively provide the first and second switching paths (60, 64).

10. A gate driver (300) according to any of Claims 6 to 9 wherein the switching stage (356) additionally includes an isolating transformer (302).

11. A gate driver assembly (400) comprising first and second gate drivers (402, 404) according to any of Claims 5 to 8, the first gate driver (402) having a first switching stage (406) which in use selectively provides a first switching path (460) between a first primary energy storage device (30A) of the first gate driver (402) and the gate terminal (26) of a switching device (18) to apply a voltage (V) at a first polarity to the said gate terminal (26), and the second gate driver (404) having a second switching stage (410) which in use selectively provides a second switching path (464) between a second primary energy storage device (30B) of the second gate driver (404) and the gate terminal (26) of the said switching device (18) to apply a voltage (V) at a second polarity, opposite to the first polarity, to the said gate terminal (26).

12. A gas tube switching device (20) comprising:
a gate terminal (26) via which it can be turned on and turned off; and
a gate driver (200; 300) according to any of Claims 5 to 10 or a gate driver assembly (400) according to Claim 11 operatively connected with the gate terminal (26) to selectively apply a voltage (V) at a first polarity to the gate terminal (26) to turn the gas tube (20) on and selectively apply a voltage (V) at a second polarity opposite the first polarity to the gate terminal (26) to turn the gas tube off (20).

## Patentansprüche

1. Geregelte Spannungsquelle (10; 10A, 10B) für einen Gate-Treiber (200; 300) für eine Gasentladungsröhren-Schaltvorrichtung (18), die einen Gate-Anschluss (26) aufweist, über den die Schaltvorrichtung (18) mindestens eingeschaltet werden kann, wobei die geregelte Spannungsquelle (10; 10A, 10B) umfasst:
einen Eingangsanschluss (12), über den die geregelte Spannungsquelle (10; 10A, 10B) in Verwendung Strom empfängt;
erste und zweite Verbindungsanschlüsse (22, 24), über mindestens einen von denen die geregelte Spannungsquelle (10; 10A, 10B) in Verwendung eine Spannung (V) an den Gate-Anschluss (26) einer Schaltvorrichtung (18) anlegt;
**dadurch gekennzeichnet, dass** die geregelte Spannungsquelle weiter umfasst:
eine geregelte Energiespeicherstufe (28), die zwischen dem Eingangs- und Ausgangsanschluss (12, 22, 24) elektrisch verbunden ist und eine primäre Energiespeichervorrichtung (30; 30A, 30B) enthält, die parallel mit einem Speicherbegrenzer (34) verbunden ist, um die Menge von in der primären Energiespeichervorrichtung (30; 30A, 30B) gespeicherter Energie zu begrenzen, und zwischen dem ein Energiezurückhalter (46) liegt, um das Entweichen von Energie aus der primären Energiespeichervorrichtung (30; 30A, 30B) über den Speicherbegrenzer (34) zu verhindern;
eine Freilaufdiode (50), die parallel mit der Energiespeicherstufe (28) angeordnet ist; und
eine sekundäre Energiespeichervorrichtung (52; 52A, 52B), die parallel mit jedem der Freilaufdiode (50) und der Energiespeicherstufe (28) angeordnet ist.

2. Geregelte Spannungsquelle (10; 10A, 10B) nach Anspruch 1, wobei die sekundäre Energiespeichervorrichtung (52; 52A, 52B) eine kleinere Speicherkapazität aufweist als die primäre Energiespeichervorrichtung (30; 30A, 30B).

3. Geregelte Spannungsquelle (10; 10A, 10B) nach Anspruch 1 oder Anspruch 2, wobei der Speicherbegrenzer (34) ein Entladungsbegrenzungselement (42) aufweist, das in Reihe damit verbunden ist.

4. Geregelte Spannungsquelle (10; 10A, 10B) nach Anspruch 3, wobei das Entladungsbegrenzungselement (42) eines von einem Induktor (44) und einem Widerstand ist oder enthält.

5. Gate-Treiber (200; 300; 402, 404) für eine Gasentladungsröhren-Schaltvorrichtung (18), die einen Gate-Anschluss (26) aufweist, über den die Schaltvorrichtung (18) mindestens eingeschaltet werden kann, umfassend eine geregelte Spannungsquelle (10; 10A, 10B) nach einem der vorstehenden Ansprüche.

6. Gate-Treiber nach Anspruch 5, wobei der erste und der zweite Ausgangsanschluss (22, 24) der geregelten Spannungsquelle (10; 10A, 10B) eine Schaltstufe (56; 356; 406, 410) aufweisen, die damit elektrisch verbunden ist, um in Verwendung wahlweise die primäre Energiespeichervorrichtung (30; 30A, 30B) der geregelten Spannungsquelle (10; 10A, 10B) mit einem Gate-Anschluss (26) einer Schaltvorrichtung (18) zusammen zu schalten.

7. Gate-Treiber (200; 300; 402) nach Anspruch 6, wobei die Schaltstufe (56; 356; 406) in Verwendung wahlweise einen ersten Koppelweg (60; 460) zwischen der primären Energiespeichervorrichtung (30; 30A) und dem Gate-Anschluss (26) bereitstellt, um eine Spannung (V) an der ersten Polarität am Gate-Anschluss (26) anzulegen.

8. Gate-Treiber (200; 300; 404) nach Anspruch 6 oder Anspruch 7, wobei die Schaltstufe (56; 356; 410) in Verwendung wahlweise einen zweiten Koppelweg (64; 464) zwischen der primären Energiespeichervorrichtung (30; 30B) und dem Gate-Anschluss (26) bereitstellt, um eine Spannung (V) an einer zweiten entgegengesetzten Polarität am Gate-Anschluss (26) anzulegen.

9. Gate-Treiber (200; 300) nach Anspruch 8, wobei die Schaltstufe (56; 356) eine Vollbrücken-Schaltanordnung (68) enthält, um wahlweise den ersten und den zweiten Koppelweg (60, 64) bereitzustellen.

10. Gate-Treiber (300) nach einem der Ansprüche 6 bis 9 wobei, die Schaltstufe (356) zusätzlich einen isolierenden Transformator (302) enthält.

11. Gate-Treiberbaugruppe (400), umfassend erste und zweite Gate-Treiber (402, 404) nach einem der Ansprüche 5 bis 8, wobei der erste Gate-Treiber (402) eine erste Schaltstufe (406) aufweist, die in Verwendung wahlweise einen ersten Koppelweg (460) zwischen einer ersten primären Energiespeichervorrichtung (30A) des ersten Gate-Treibers (402) und dem Gate-Anschluss (26) einer Schaltvorrichtung (18) bereitstellt, um eine Spannung (V) an einer ersten Polarität an dem Gate-Anschluss (26) anzulegen, und der zweite Gate-Treiber (404) eine zweite Schaltstufe (410) aufweist, die in Verwendung wahlweise einen zweiten Koppelweg (464) zwischen einer zweiten primären Energiespeichervorrichtung (30B) des zweiten Gate-Treibers (404) und dem Gate-Anschluss (26) der Schaltvorrichtung (18) bereitstellt, um eine Spannung (V) an einer zweiten Polarität, die der ersten Polarität entgegengesetzt ist, am Gate-Anschluss (26) anzulegen.

12. Gasentladungsröhren-Schaltvorrichtung (20), umfassend:
einen Gate-Anschluss (26), über den sie eingeschaltet und ausgeschaltet werden kann; und
einen Gate-Treiber (200; 300) nach einem der Ansprüche 5 bis 10 oder eine Gate-Treiberbaugruppe (400) nach Anspruch 11, die betriebsmäßig mit dem Gate-Anschluss (26) verbunden ist, um wahlweise eine Spannung (V) an einer ersten Polarität am Gate-Anschluss (26) anzulegen, um die Gasentladungsröhre (20) einzuschalten, und wahlweise eine Spannung (V) an einer zweiten Polarität, die der ersten Polarität entgegengesetzt ist, am Gate-Anschluss (26) anzulegen, um die Gasentladungsröhre (20) auszuschalten.

## Revendications

1. Source de tension régulée (10 ; 10A, 10B) pour un pilote de grille (200 ; 300) pour un dispositif de commutation de tube à gaz (18) ayant une borne de grille (26) via laquelle le dispositif de commutation (18) peut au moins être mis sous tension, la source de tension régulée (10 ; 10A, 10B) comprenant :
une borne d'entrée (12) via laquelle la source de tension régulée (10 ; 10A, 10B) en service reçoit du courant ;
des première et seconde bornes de connexion (22, 24) via au moins une desquelles la source de tension régulée (10 ; 10A, 10B) en service applique une tension (V) à une borne de grille (26) d'un dispositif de commutation (18) ;
**caractérisée en ce que** la source de tension régulée comprend en outre :
un étage de stockage d'énergie régulé (28) connecté électriquement entre les bornes d'entrée et de sortie (12, 22, 24) et incluant un dispositif de stockage d'énergie primaire (30 ; 30A, 30B) connecté en parallèle à un limiteur de stockage (34) pour limiter la quantité d'énergie stockée dans le dispositif de stockage d'énergie primaire (30 ; 30A, 30B) et entre lesquels se trouve un dispositif de retenue d'énergie (46) pour empêcher la fuite d'énergie à partir du dispositif de stockage d'énergie primaire (30 ; 30A, 30B) via le limiteur de stockage (34) ;
une diode à roue libre (50) agencée en parallèle avec l'étage de stockage d'énergie (28) ; et
un dispositif de stockage d'énergie secondaire (52 ; 52A, 52B) agencé en parallèle avec chacun de la diode à roue libre (50) et de l'étage de stockage d'énergie (28).

2. Source de tension régulée (10 ; 10A, 10B) selon la revendication 1, dans laquelle le dispositif de stockage d'énergie secondaire (52 ; 52A, 52B) a une capacité de stockage inférieure au dispositif de stockage d'énergie primaire (30 ; 30A, 30B).

3. Source de tension régulée (10 ; 10A, 10B) selon la revendication 1 ou la revendication 2, dans laquelle le limiteur de stockage (34) a un élément de limitation de décharge (42) connecté en série avec celui-ci.

4. Source de tension régulée (10; 10A, 10B) selon la revendication 3, dans laquelle l'élément de limitation de décharge (42) est ou inclut l'une d'une inductance (44) et d'une résistance.

5. Pilote de grille (200 ; 300 ; 402, 404), pour un dispositif de commutation de tube à gaz (18) ayant une borne de grille (26) via laquelle le dispositif de commutation (18) peut au moins être mis sous tension, comprenant une source de tension régulée (10 ; 10A, 10B) selon l'une quelconque des revendications précédentes.

6. Pilote de grille selon la revendication 5, dans laquelle les première et seconde bornes de sortie (22, 24) de la source de tension régulée (10 ; 10A, 10B) ont un étage de commutation (56 ; 356 ; 406, 410) connecté électriquement à celles-ci pour, en service, interconnecter sélectivement le dispositif de stockage d'énergie primaire (30 ; 30A, 30B) de la source de tension régulée (10 ; 10A, 10B) avec une borne de grille (26) d'un dispositif de commutation (18).

7. Pilote de grille (200 ; 300 ; 402) selon la revendication 6, dans laquelle l'étage de commutation (56 ; 356 ; 406), en service, fournit sélectivement un premier trajet de commutation (60 ; 460) entre le dispositif de stockage d'énergie primaire (30 ; 30A) et la borne de grille (26) pour appliquer une tension (V) d'une première polarité à la borne de grille (26).

8. Pilote de grille (200; 300; 404) selon la revendication 6 ou 7, dans laquelle l'étage de commutation (56 ; 356 ; 410), en service, fournir sélectivement un second chemin de commutation (64 ; 464) entre le dispositif de stockage d'énergie primaire (30; 30B) et la borne de grille (26) pour appliquer une tension (V) d'une seconde polarité opposée à la borne de grille (26).

9. Pilote de grille (200; 300) selon la revendication 8, dans laquelle l'étage de commutation (56 ; 356) inclut un agencement de commutation en pont complet (68) pour fournir sélectivement les premier et second trajet de commutation (60, 64).

10. Pilote de grille (300) selon l'une quelconque des revendications 6 à 9, dans lequel l'étage de commutation (356) inclut de plus transformateur d'isolement (302).

11. Ensemble de pilotes de grille (400) comprenant des premier et second pilotes de grille (402, 404) selon l'une quelconque des revendications 5 à 8, le premier pilote de grille (402) ayant un premier étage de commutation (406) qui, en service, fournit sélectivement un premier trajet de commutation (460) entre un premier dispositif de stockage d'énergie primaire (30A) du premier pilote de grille (402) et la borne de grille (26) d'un dispositif de commutation (18) pour appliquer une tension (V) d'une première polarité à ladite borne de grille (26), et le second pilote de grille (404) ayant un second étage de commutation (410) qui, en service, fournit sélectivement un second trajet de commutation (464) entre un second dispositif de stockage d'énergie primaire (30B) du second pilote de grille (404) et la borne de grille (26) dudit dispositif de commutation (18) pour appliquer une tension (V) d'une seconde polarité, opposée à la première polarité, à ladite borne de grille (26).

12. Dispositif de commutation de tube à gaz (20) comprenant :
une borne de grille (26) via laquelle il peut être mis sous tension et éteint ; et
un pilote de grille (200 ; 300) selon l'une quelconque des revendications 5 à 10 ou un ensemble de pilotes de grille (400) selon la revendication 11, connecté de manière opérationnelle à la borne de grille (26) pour appliquer sélectivement une tension (V) d'une première polarité à la borne de grille (26) pour mettre le tube à gaz (20) sous tension et appliquer sélectivement une tension (V) d'une seconde polarité opposée à la première polarité à la borne de grille (26) pour éteindre le tube à gaz (20).
